# EUROPEAN PATENT APPLICATION

(11) **EP 4 750 272 A1**
(43) Date of publication of application: **27.05.2026**
(21) Application number: 25215954.6
(22) Date of filing: 14.11.2025
(51) Int. Cl.: H10F 39/12, H10F 39/00

(54) **A PHOTOELECTRIC CONVERSION DEVICE, A RECEIVING SENSOR AND A LIDAR**

(30) Priority: 20.11.2024 CN 202411671874
(71) Applicant: Suteng Innovation Technology Co., Ltd, Shenzhen City Guangdong 518000 (CN)
(72) Inventor: CHAO, Enfei, Shenzhen City (CN); YAO, Guofeng, Shenzhen City (CN); XIA, Chunqiu, Shenzhen City (CN)
(74) Representative: Ran, Handong

(57) **Abstract**

A photoelectric conversion device, a fabrication method, and an image sensor are disclosed. The device includes a substrate with at least two avalanche diode units. Each unit has a device region surrounded by a back-side deep trench isolation structure. At least one front-side trench isolation structure is disposed between any two adjacent units. A doped region, formed by outward diffusion from the front-side trench isolation structure, has a gradually decreasing doping concentration gradient. At least a portion of the doped region extends beyond the back-side deep trench isolation structure to form a dark current suppression region within each adjacent avalanche diode unit. This configuration reduces the dark count rate (DCR) of the device, thereby enhancing its electrical performance and reliability.

## Description

### TECHNICAL FIELD

The embodiments of the present invention relate to the field of semiconductors, and in particular, to a photoelectric conversion device, a fabrication method thereof, and an image sensor.

### BACKGROUND

Single Photon Avalanche Diodes (SPADs) have been widely adopted in applications such as LiDAR systems, autonomous driving, fluorescence lifetime imaging, quantum communication, and biomedical imaging due to their high sensitivity in detecting signals as weak as single photons, excellent temporal resolution, and strong anti-interference capabilities.

The Dark Count Rate (DCR) refers to the frequency at which dark carriers generated within the SPAD due to various effects trigger avalanche counts in the absence of incident light. DCR is one of the core performance metrics of SPADs, significantly impacting the signal-to-noise ratio in LiDAR systems and thereby influencing critical performance aspects such as ranging accuracy.

In conventional back-illuminated SPAD structures, Back-side Deep Trench Isolation (BDTI) is commonly employed for optical and electrical isolation between adjacent SPAD devices. The BDTI is formed by etching from the backside of the silicon substrate and subsequently filled with tungsten and a high dielectric constant medium (High K material). However, the etching process for BDTI introduces numerous surface defects, which generate a large number of dark carriers and lead to an increase in the DCR of the device. To address this issue, Front-side Trench Isolation (FTI) has been introduced into SPAD fabrication processes. The FTI consists of silicon material with a specific doping concentration. When the doping concentration of the FTI is sufficiently high, it can effectively recombine the dark carriers generated by the BDTI and induce a pinning effect on the BDTI surface, thereby reducing the probability of dark carrier generation. However, in practice, the etching process for FTI introduces new surface defects, which may result in an even higher DCR.

### SUMMARY

The primary technical problem addressed by the embodiments of the present invention is to provide an image sensor, a photoelectric conversion device, and a fabrication method thereof, which can mitigate the issue of increased DCR caused by surface defects.

To resolve the aforementioned technical problem, one technical solution adopted in the embodiments of the present invention is to provide a photoelectric conversion device, comprising:
a substrate;
a front-side trench isolation structure;
at least two avalanche diode units formed in the substrate, each of the avalanche diode units comprising a device region and a back-side deep trench isolation structure surrounding the device region; and
a doped region formed by outward diffusion from the front-side trench isolation structure, the doped region having a doping concentration gradient that gradually decreases outward from the front-side trench isolation structure;
wherein at least one front-side trench isolation structure is provided between any two adjacent avalanche diode units; and
at least a portion of the doped region extends beyond the back-side deep trench isolation structure, forming a dark current suppression region in each of the two adjacent avalanche diode units.

In some embodiments, one front-side trench isolation structure is disposed between any two adjacent avalanche diode units; wherein the front-side trench isolation structure is located between the back-side deep trench isolation structures of the two adjacent avalanche diode units.

In some embodiments, a first distance is less than a second distance;
wherein the first distance is a distance between a centerline of the front-side trench isolation structure and an inner side of the back-side deep trench isolation structure of an adjacent avalanche diode unit;
the second distance is a distance between the centerline of the front-side trench isolation structure and a minimum effective concentration boundary of the doped region, wherein the minimum effective concentration boundary has a predetermined doping concentration.

In some embodiments, each avalanche diode unit has a corresponding front-side trench isolation structure;
wherein the corresponding front-side trench isolation structure surrounds the back-side deep trench isolation structure of the avalanche diode unit, and the front-side trench isolation structure is located outside the back-side deep trench isolation structure.

In some embodiments, a third distance is less than a fourth distance;
wherein the third distance is a distance between an outer side of the back-side deep trench isolation structure of the avalanche diode unit and a centerline of the corresponding front-side trench isolation structure;
the fourth distance is a distance between the centerline of the corresponding front-side trench isolation structure and a minimum effective concentration boundary of the doped region formed by diffusion from the corresponding front-side trench isolation structure, wherein the minimum effective concentration boundary has a predetermined doping concentration.

In some embodiments, the back-side deep trench isolation structure is a first etched trench filled with an isolation material;
wherein the isolation material comprises a metal and a high-dielectric-constant dielectric material.

In some embodiments, the first etched trench is formed by an etching process from a first surface of the substrate.

In some embodiments, a microlens is further disposed on the first surface of the substrate.

In some embodiments, the front-side trench isolation structure is a second etched trench formed by growing silicon material through vapor-phase epitaxy;
wherein the silicon material is doped with impurities.

In some embodiments, the front-side trench isolation structure is defined by a second etched trench;
wherein the second etched trench is formed by an etching process from a second surface of the substrate, and the second surface is opposite to the first surface.

To resolve the aforementioned technical problem, another technical solution adopted in the embodiments of the present invention is to provide an image sensor, comprising:
the photoelectric conversion device as described above;
an analog front-end circuit configured to convert analog electrical signals generated by the photoelectric conversion device into digital signals;
a digital processor configured to perform noise filtering and digital signal smoothing on the digital signals.

To resolve the aforementioned technical problem, another technical solution adopted in the embodiments of the present invention is to provide a method for fabricating a photoelectric conversion device, comprising:
forming at least two device regions in a substrate, each of the device regions comprising a first doped region and a second doped region;
forming at least one front-side trench isolation structure extending from a second surface of the substrate into the interior of the substrate, wherein the at least one front-side trench isolation structure separates any two adjacent device regions;
causing impurities doped in the front-side trench isolation structure to diffuse outward from the front-side trench isolation structure within the substrate to form a doped region;
forming at least two back-side deep trench isolation structures from a first surface of the substrate within the doped region, such that a dark current suppression region is formed inside the back-side deep trench isolation structures;
wherein one of the back-side deep trench isolation structures surrounds one of the device regions, and the front-side trench isolation structure is located outside the back-side deep trench isolation structures.

In some embodiments, forming at least one front-side trench isolation structure extending from the second surface of the substrate into the interior of the substrate comprises:
etching a second etched trench from the second surface of the substrate;
growing silicon material doped with impurities in the second etched trench to form a front-side trench isolation structure.

In some embodiments, forming at least one front-side trench isolation structure extending from the second surface of the substrate into the interior of the substrate comprises:
etching at least two second etched trenches from the second surface of the substrate, wherein one of the second etched trenches surrounds one of the back-side deep trench isolation structures;
growing silicon material doped with impurities in the at least two second etched trenches to form at least two front-side trench isolation structures.

The beneficial effects of the embodiments of the present invention are as follows: Unlike the prior art, the embodiments of the present invention prevent the formation of new surfaces in the device region by the front-side trench isolation structure by surrounding the device region with the back-side deep trench isolation structure. This avoids the increase in dark count rate caused by new surface defects, thereby reducing the dark count rate of the device and improving its electrical performance and reliability.

### BRIEF DESCRIPTION OF DRAWINGS

Reference will now be made to the accompanying drawings to describe embodiments of the present invention by way of example. One or more embodiments are illustratively shown in the figures. These illustrative descriptions do not limit the embodiments. For convenience, identical or similar elements are denoted by identical or similar reference numerals in the drawings. Unless otherwise specified, the figures in the drawings are not to scale.
FIG. 1 is a schematic cross-sectional view of a conventional back-illuminated single-photon avalanche diode;
FIG. 2 is a schematic cross-sectional view of a first photoelectric conversion device according to an embodiment of the present invention;
FIG. 3 is a top view of the first photoelectric conversion device according to an embodiment of the present invention;
FIG. 4 is a schematic cross-sectional view of a second photoelectric conversion device according to an embodiment of the present invention;
FIG. 5 is a top view of the second photoelectric conversion device according to an embodiment of the present invention;
FIG. 6 is a schematic cross-sectional view of a third photoelectric conversion device according to an embodiment of the present invention;
FIG. 7 is a top view of the third photoelectric conversion device according to an embodiment of the present invention;
FIG. 8 is a schematic flowchart of a method for fabricating a photoelectric conversion device according to an embodiment of the present invention;
FIG. 9 is a schematic sub-flowchart of step S200 in the fabrication method of the photoelectric conversion device shown in FIG. 8;
FIG. 10 is another schematic sub-flowchart of step S200 in the fabrication method of the photoelectric conversion device shown in FIG. 8.

### DETAILED DESCRIPTION

To facilitate the understanding of the present application, the following description provides a more detailed explanation of the present application with reference to the accompanying drawings and specific embodiments. It should be noted that when an element is described as being "fixed to" another element, it may be directly on the other element, or there may be one or more intervening elements between them. When an element is described as being "connected" to another element, it may be directly connected to the other element, or there may be one or more intervening elements between them. The terms "upper," "lower," "inner," "outer," "bottom," and other directional or positional relationships used in this specification are based on the directional or positional relationships shown in the accompanying drawings. These terms are used merely for the convenience of describing the present application and simplifying the description, and do not indicate or imply that the referred device or element must have a specific orientation or be constructed and operated in a specific orientation. Therefore, these terms should not be construed as limiting the present application. Furthermore, terms such as "first," "second," and "third" are used for descriptive purposes only and should not be interpreted as indicating or implying relative importance.

Unless otherwise defined, all technical and scientific terms used herein have the same meanings as commonly understood by those skilled in the technical field of the present application. The terminology used in the description of the present application herein is for the purpose of describing specific embodiments only and is not intended to limit the present application. The term "and/or" as used herein includes any and all combinations of one or more of the associated listed items.

Furthermore, the technical features involved in the different embodiments of the present application described below may be combined with each other as long as they do not conflict with one another.

The technical solutions of the present application will be described below in conjunction with the accompanying drawings.

Integrated circuit (IC) technology continues to advance, with progress reflected in reducing device dimensions to achieve lower manufacturing costs, higher device integration density, faster speeds, and improved performance. As device sizes shrink, the pixels in the pixel array of image sensors become smaller and closer to each other. There is a need to enhance both electrical and optical isolation between adjacent pixels of such image sensors to reduce blooming and crosstalk. Dielectric trenches and implant wells can be fabricated as isolation structures to isolate pixels in image sensors.

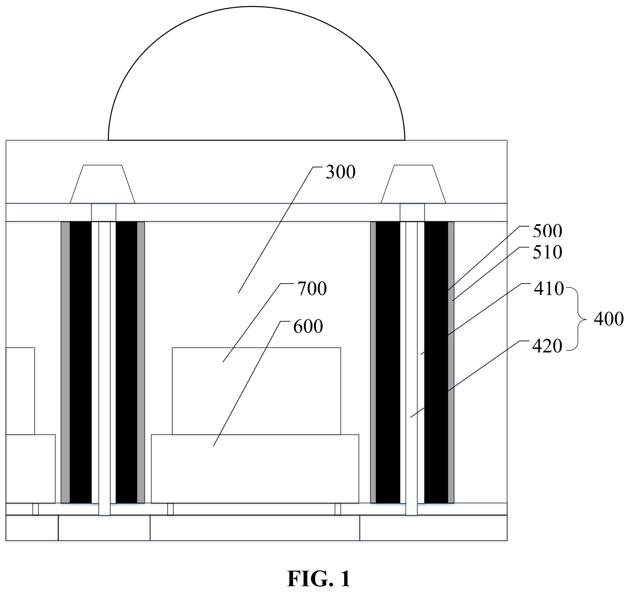

Back-illuminated Single Photon Avalanche Diodes (SPADs) have become a mainstream image sensor technology for both commercial and scientific applications. A schematic cross-sectional view of such a back-illuminated SPAD is shown in FIG. 1. A first doped region 600 and a second doped region 700 are formed within the substrate 300. At the PN junction formed by the first doped region 600 and the second doped region 700, photons are absorbed and generate electron-hole pairs.

A front-side trench isolation structure 500 is formed by etching from the front side of the substrate 300, and a back-side deep trench isolation structure 400 is formed by etching from the back side of the substrate 300. The back-side deep trench isolation structure 400 comprises a doped layer 410 and a dielectric fill layer 420. Since the front-side trench isolation structure 500 is made of silicon material with a specific doping concentration, when the doping concentration of the front-side trench isolation structure 500 is sufficiently high, it will recombine the dark carriers generated by the back-side deep trench isolation structure 400. Simultaneously, it induces a pinning effect on the surface of the back-side deep trench isolation structure 400, thereby reducing the probability of dark carrier generation.

The fabrication process of the front-side trench isolation structure 500 is as follows: In the substrate 300, a front-side trench etching process is first performed, followed by silicon material growth via vapor-phase epitaxy to fill the front-side trench. Finally, a thermal diffusion process is employed to form a region with high doping concentration and a specific concentration gradient within the substrate 300, aiming to suppress dark carriers generated at the surface of the back-side deep trench isolation structure 400. However, during the formation of the front-side trench isolation structure 500, the etching process introduces new interface defects. Specifically, the interface between the front-side trench isolation structure 500 and the substrate 300 also contains a significant number of defects, making it impractical to utilize the front-side trench isolation structure 500 to reduce the dark count rate.

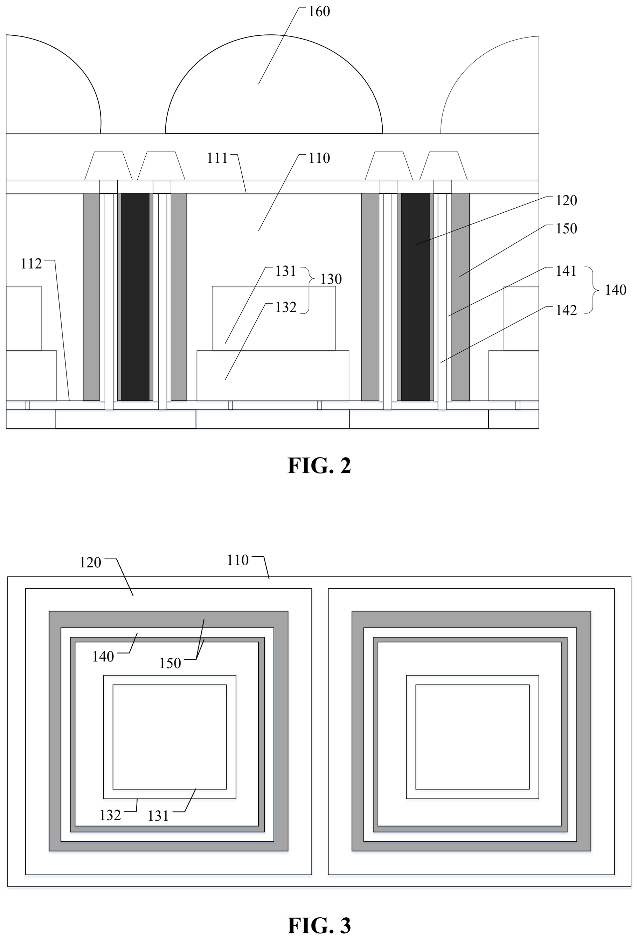

To address this issue, an embodiment of the present invention provides a photoelectric conversion device. A schematic cross-sectional view of the device is shown in FIG. 2, and a top view is shown in FIG. 3. The photoelectric conversion device comprises a substrate 110, a front-side trench isolation structure 120, a device region 130, a back-side deep trench isolation structure 140, a doped region 150, and a microlens 160. The device region 130 includes a first doped region 132 and a second doped region 131.

The substrate 110 serves as the foundational material for the entire device, providing mechanical support and semiconductor properties. The substrate 110 has a second surface 112 and a first surface 111. The first surface 111 is a first dielectric layer, which functions to reduce reflection of incident light. The second surface 112 is a second dielectric layer, which is disposed between the single-photon avalanche diode and the front-side metal routing layer. The front-side metal routing layer is electrically connected to the corresponding single-photon avalanche diode via contact metal wires. In the embodiments of the present application, the substrate 110 may comprise any form of semiconductor body and doping (where the body may be, for example, a silicon bulk/CMOS bulk, silicon germanium, silicon-on-insulator, etc.), such as a semiconductor wafer or one or more dies on a wafer. Additionally, other forms of semiconductor and/or epitaxial layers may be formed on and/or in other forms of relation to the aforementioned semiconductor body.

The substrate 110 includes at least two avalanche diode units formed therein. Each avalanche diode unit comprises a device region 130 and a back-side deep trench isolation structure 140 surrounding the device region 130. The device region 130 is configured to convert incident radiation or incident light (e.g., photons) into an electrical signal. In some embodiments, the device region 130 includes a first doped region 132 and an adjacent second doped region 131. The first doped region 132 is located within the substrate 110 and has a first doping type (e.g., p-type doping), while the second doped region 131 is also located within the substrate 110 and has a second doping type (e.g., n-type doping).

The back-side deep trench isolation structure 140 is embedded in the substrate 110 and extends from the back-side first dielectric layer 111 to the second dielectric layer 112 of the substrate 110. In a preferred embodiment, the back-side deep trench isolation structure 140 may extend into the interior of the second dielectric layer 112, wherein the depth of the back-side deep trench isolation structure 140 within the second dielectric layer 112 may be less than or equal to the thickness of the second dielectric layer 112. As shown in FIG. 3, one back-side deep trench isolation structure 140 surrounds one device region 130 to isolate adjacent device regions 130. In some embodiments, the back-side deep trench isolation structure 140 comprises a doped layer 141 and a dielectric fill layer 142 (specifically, a metal and a high-k dielectric material). The doped layer 141 has the aforementioned first doping type (e.g., p-type doping). The doped layer 141 is arranged along a sidewall surface of a first etched trench, and the dielectric fill layer 142 fills the remaining space of the deep trench. In the embodiments of the present application, the first etched trench is formed by an etching process from the first surface 111 of the substrate.

The front-side trench isolation structure 120 is embedded in the substrate 110 and extends from the front-side second dielectric layer 112 to the first dielectric layer 111 of the substrate 110. As shown in FIG. 3, one front-side trench isolation structure 120 is disposed between any two adjacent avalanche diode units, wherein the front-side trench isolation structure 120 is located between the back-side deep trench isolation structures 140 of the two adjacent avalanche diode units. In some embodiments, the front-side trench isolation structure 120 is formed by growing silicon material with a specific doping concentration via vapor-phase epitaxy in a second etched trench. In the embodiments of the present application, the second etched trench is formed by an etching process from the second surface 112 of the substrate.

The doped region 150 is formed by outward thermal diffusion of impurities doped in the front-side trench isolation structure 120, exhibiting a doping concentration gradient that gradually decreases from the front-side trench isolation structure 120 outward. It should be noted that, in terms of the formation sequence, the front-side trench isolation structure 120 is formed prior to the back-side deep trench isolation structure 140, ensuring that the back-side deep trench isolation structure 140 is formed within the doped region 150. This is manifested by at least a portion of the doped region 150 extending beyond the back-side deep trench isolation structure 140 and into the avalanche diode unit, thereby achieving the purpose of encapsulating the interface between the back-side deep trench isolation structure 140 and the substrate 110. As a result, a dark current suppression region is formed in both of the two adjacent avalanche diode units. Within the dark current suppression region, dark carriers generated by surface defects at the interface between the back-side deep trench isolation structure 140 and the substrate 110 recombine with holes in the doped region 150. This mechanism reduces the dark count rate of the single-photon avalanche diode, thereby enhancing its signal-to-noise ratio and overall performance. The improved reliability and accuracy of the single-photon avalanche diode in various applications consequently enhance the ranging performance of the LiDAR system.

The distance between the centerline of the front-side trench isolation structure 120 and the inner side of the back-side deep trench isolation structure 140 of an adjacent avalanche diode unit is defined as the first distance. The distance between the centerline of the front-side trench isolation structure 120 and the minimum effective concentration boundary of the doped region 150 is defined as the second distance, where the minimum effective concentration boundary corresponds to a predetermined doping concentration. In the embodiments of the present application, to ensure that the doped region 150 fully encapsulates the interface between the back-side deep trench isolation structure 140 and the substrate 110, it is necessary to maintain the condition that the first distance is less than the second distance. This guarantees that the doped region 150 extends sufficiently to cover the critical interface, thereby enabling effective suppression of dark carriers generated at the surface defects.

The microlenses 160 are arranged on the first surface 111 of the substrate 110, each aligned with a corresponding device region 130, to focus incident light and enhance photon detection efficiency. Between the microlenses 160 and the first surface 111, a metal layer (not labeled as it is not part of the present application) is additionally disposed.

In some embodiments, the plurality of microlenses 160 each have a substantially flat bottom surface and a curved top surface. The substantially flat bottom surface is adjacent to the aforementioned metal layer. The curved top surface is configured to focus incident radiation or incident light. During operation of the photoelectric conversion device, the microlenses 160 focus incident radiation or incident light onto the underlying device regions 130. When incident radiation or incident light with sufficient energy strikes the device region 130, it generates an electron-hole pair, thereby producing a photocurrent. It should be noted that while FIG. 2 illustrates microlenses 160 fixed to the photoelectric conversion device, the photoelectric conversion device may not necessarily include microlenses. Alternatively, the microlenses may be attached to the photoelectric conversion device in a separate manufacturing step.

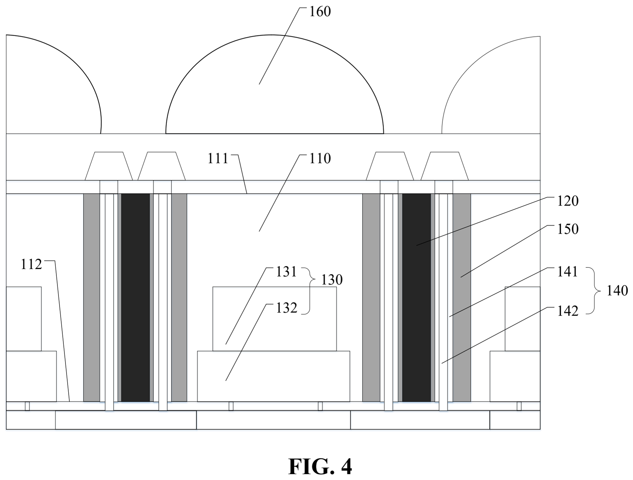

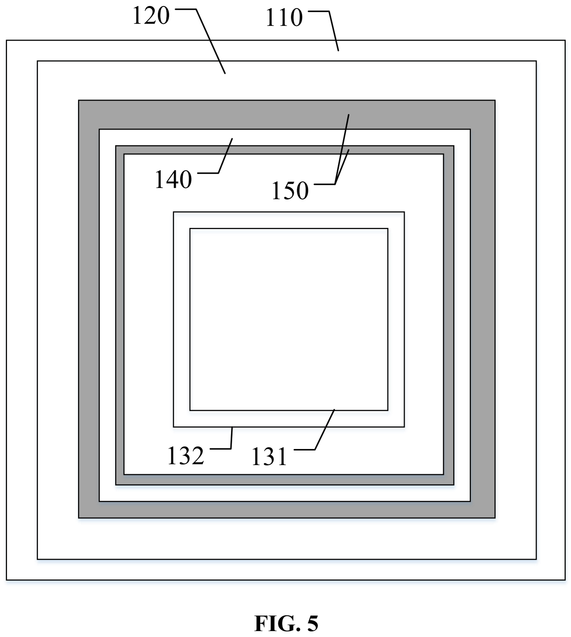

Furthermore, an embodiment of the present invention provides another photoelectric conversion device. A schematic cross-sectional view of the device is shown in FIG. 4, and a top view is shown in FIG. 5. The schematic cross-sectional view of this photoelectric conversion device is similar to that of FIG. 2. The device similarly comprises a substrate 110, a front-side trench isolation structure 120, a device region 130, a back-side deep trench isolation structure 140, a doped region 150, and a microlens 160. The device region 130 includes a first doped region 132 and a second doped region 131.

The substrate 110 serves as the foundational material for the entire device, providing mechanical support and semiconductor properties. The substrate 110 comprises a second dielectric layer 112 and a first dielectric layer 111. In the embodiments of the present application, the substrate 110 may include any form of semiconductor body (e.g., silicon bulk/CMOS bulk, silicon germanium, silicon-on-insulator, etc.), such as a semiconductor wafer or one or more dies on a wafer. Additionally, other forms of semiconductor and/or epitaxial layers may be formed on and/or in other forms of relation to the aforementioned semiconductor body.

The substrate 110 includes at least two avalanche diode units formed therein. Each avalanche diode unit comprises a device region 130 and a back-side deep trench isolation structure 140 surrounding the device region 130. The device region 130 is configured to convert incident radiation or incident light (e.g., photons) into an electrical signal. In some embodiments, the device region 130 includes a first doped region 132 and an adjacent second doped region 131. The first doped region 132 is located within the substrate 110 and has a first doping type (e.g., p-type doping), while the second doped region 131 is also located within the substrate 110 and has a second doping type (e.g., n-type doping).

The back-side deep trench isolation structure 140 is embedded in the substrate 110 and extends from the back-side first dielectric layer 111 to the second dielectric layer 112 of the substrate 110. As shown in FIG. 5, one back-side deep trench isolation structure 140 surrounds one device region 130 to isolate adjacent device regions 130. In some embodiments, the back-side deep trench isolation structure 140 comprises a doped layer 141 and a dielectric fill layer 142 (specifically, a metal and a high-k dielectric material). The doped layer 141 has the aforementioned first doping type (e.g., p-type doping). The doped layer 141 is arranged along a sidewall surface of a first etched trench, and the dielectric fill layer 142 fills the remaining space of the deep trench. In the embodiments of the present application, the first etched trench is formed by an etching process from the first surface 111 of the substrate.

The front-side trench isolation structure 120 is embedded in the substrate 110 and extends from the front-side second dielectric layer 112 to the first dielectric layer 111 of the substrate 110. As shown in FIG. 5, each avalanche diode unit has a corresponding front-side trench isolation structure 120. The corresponding front-side trench isolation structure 120 surrounds the back-side deep trench isolation structure 140 of the avalanche diode unit, with the front-side trench isolation structure 120 located outside the back-side deep trench isolation structure 140. In some embodiments, the front-side trench isolation structure 120 is formed by growing silicon material with a specific doping concentration via vapor-phase epitaxy in a second etched trench. In the embodiments of the present application, the second etched trench is formed by an etching process from the second surface 112 of the substrate.

The doped region 150 is formed by outward thermal diffusion of impurities doped in the front-side trench isolation structure 120, exhibiting a doping concentration gradient that gradually decreases from the front-side trench isolation structure 120 outward. It is important to note that, in terms of the fabrication sequence, the front-side trench isolation structure 120 is formed prior to the back-side deep trench isolation structure 140, ensuring that the back-side deep trench isolation structure 140 is formed within the doped region 150. This is manifested by at least a portion of the doped region 150 extending beyond the back-side deep trench isolation structure 140 and into the avalanche diode unit, thereby achieving the objective of encapsulating the interface between the back-side deep trench isolation structure 140 and the substrate 110. As a result, a dark current suppression region is formed in both of the two adjacent avalanche diode units. Within the dark current suppression region, dark carriers generated by surface defects at the interface between the back-side deep trench isolation structure 140 and the substrate 110 recombine with holes in the doped region 150.

The distance between the outer side of the back-side deep trench isolation structure of the avalanche diode unit and the centerline of the corresponding front-side trench isolation structure is defined as the third distance. The distance between the centerline of the corresponding front-side trench isolation structure and the minimum effective concentration boundary of the doped region formed by diffusion from the corresponding front-side trench isolation structure is defined as the fourth distance, where the minimum effective concentration boundary corresponds to a predetermined doping concentration. In the embodiments of the present application, to ensure that the doped region 150 fully encapsulates the interface between the back-side deep trench isolation structure 140 and the substrate 110, it is necessary to maintain the condition that the third distance is less than the fourth distance. This guarantees that the doped region 150 extends sufficiently to cover the critical interface, thereby enabling effective suppression of dark carriers generated at the surface defects.

The microlenses 160 are arranged on the first surface 111 of the substrate 110, each aligned with a corresponding device region 130 to focus incident light and enhance photon collection efficiency. A metal layer (not labeled as it is not part of the present application) is additionally disposed between the microlenses 160 and the first surface 111.

In some embodiments, the plurality of microlenses 160 each have a substantially flat bottom surface and a curved top surface. The substantially flat bottom surface is adjacent to the aforementioned metal layer. The curved top surface is configured to focus incident radiation or incident light. During operation of the photoelectric conversion device, the microlenses 160 focus incident radiation or incident light onto the underlying device regions 130. When incident radiation or incident light with sufficient energy strikes the device region 130, it generates an electron-hole pair, thereby producing a photocurrent. It should be noted that while FIG. 4 illustrates microlenses 160 fixed to the photoelectric conversion device, the photoelectric conversion device may not necessarily include microlenses. Alternatively, the microlenses may be attached to the photoelectric conversion device in a separate manufacturing step.

Unlike the prior art, the embodiments of the present invention utilize the back-side deep trench isolation structure surrounding the device region to avoid introducing new interface defects during the formation of the front-side trench isolation structure. This approach prevents the increase in dark count rate caused by such new interface defects, thereby reducing the dark count rate of the device and enhancing its electrical performance and reliability.

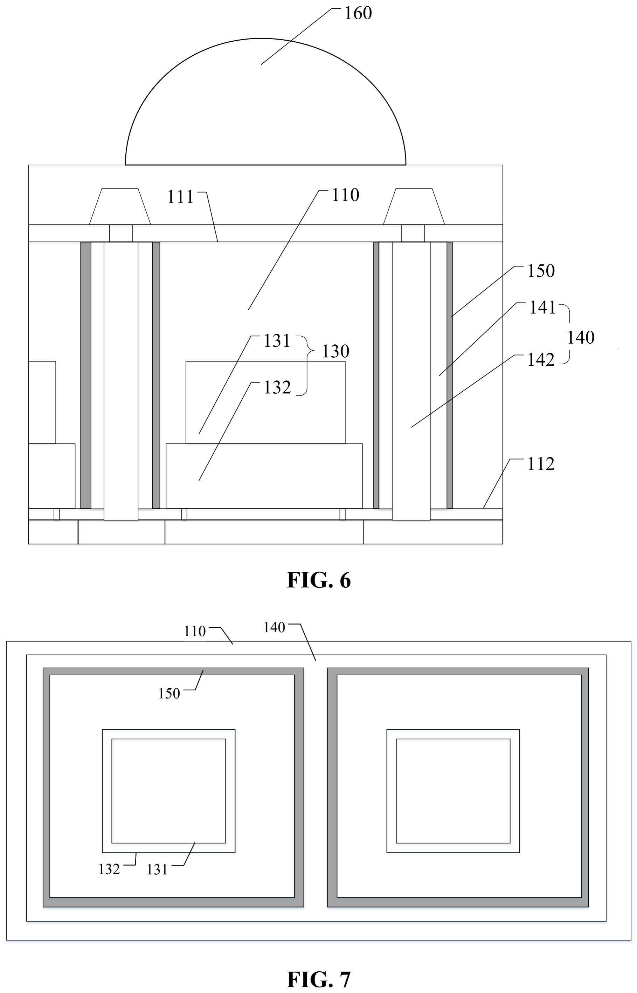

The embodiments of the present invention provide another photoelectric conversion device. A schematic cross-sectional view of the device is shown in FIG. 6, and a top view is shown in FIG. 7. The schematic cross-sectional view of this device is similar to that of FIG. 2. The photoelectric conversion device similarly comprises a substrate 110, a device region 130, a back-side deep trench isolation structure 140, a doped region 150, and a microlens 160. The device region 130 includes a first doped region 132 and a second doped region 131.

The substrate 110 serves as the foundational material for the entire device, providing mechanical support and semiconductor properties. The substrate 110 has a second surface 112 and a first surface 111. In the embodiments of the present application, the substrate 110 may include any form of semiconductor body (e.g., silicon bulk/CMOS bulk, silicon germanium, silicon-on-insulator, etc.), such as a semiconductor wafer or one or more dies on a wafer. Additionally, other forms of semiconductor and/or epitaxial layers may be formed on and/or in other forms of relation to the aforementioned semiconductor body.

The substrate 110 includes at least two avalanche diode units formed thereon. Each avalanche diode unit comprises a device region 130 and a back-side deep trench isolation structure 140 surrounding the device region 130. The device region 130 is configured to convert incident radiation or incident light (e.g., photons) into an electrical signal. In some embodiments, the device region 130 includes a first doped region 132 and an adjacent second doped region 131. The first doped region 132 is located within the substrate 110 and has a first doping type (e.g., p-type doping), while the second doped region 131 is also located within the substrate 110 and has a second doping type (e.g., n-type doping).

It should be noted that, in the embodiments of the present application, the front-side trench isolation structure exists at a certain stage and is similarly embedded in the substrate 110, extending from the front-side second dielectric layer 112 to the first dielectric layer 111 of the substrate 110. The front-side trench isolation structure is disposed between any two adjacent avalanche diode units to separate the back-side deep trench isolation structures 140 of the two adjacent avalanche diode units. Additionally, the front-side trench isolation structure is formed by growing silicon material with a specific doping concentration via vapor-phase epitaxy in a second etched trench. In the embodiments of the present application, the second etched trench is formed by an etching process from the second surface 112 of the substrate.

The doped region 150 is formed by outward thermal diffusion of impurities doped in the front-side trench isolation structure, exhibiting a doping concentration gradient that gradually decreases from the front-side trench isolation structure outward. It is known that, in terms of the fabrication sequence, the front-side trench isolation structure is formed prior to the back-side deep trench isolation structure. In the embodiments of the present application, similar to the back-illuminated single-photon avalanche diode shown in FIG. 1, the back-side deep trench isolation structure 140 is also initially embedded within the front-side trench isolation structure. However, unlike the conventional approach, during the etching process for forming the back-side deep trench isolation structure 140, its width is designed to be larger than that of the front-side trench isolation structure. This ensures that the back-side deep trench isolation structure 140 completely etches away the front-side trench isolation structure, including the interface between the front-side trench isolation structure and the substrate 110, which contains a high density of defects. Only the doped region 150 formed by thermal diffusion from the front-side trench isolation structure remains. This achieves the objective of encapsulating the interface between the back-side deep trench isolation structure 140 and the substrate 110 with the doped region 150, thereby forming a dark current suppression region in both of the two adjacent avalanche diode units. Within the dark current suppression region, dark carriers generated by surface defects at the interface between the back-side deep trench isolation structure 140 and the substrate 110 recombine with holes in the doped region 150. This mechanism reduces the dark count rate of the single-photon avalanche diode, thereby enhancing its signal-to-noise ratio and overall performance. The improved reliability and accuracy of the single-photon avalanche diode in various applications consequently enhance the ranging performance of the LiDAR system.

The microlenses 160 are arranged on the first surface 111 of the substrate 110, each aligned with a corresponding device region 130 to focus incident light and enhance photon collection efficiency. A metal layer (not labeled as it is not part of the present application) is additionally disposed between the microlenses 160 and the first surface 111.

In some embodiments, the plurality of microlenses 160 have a curved top surface configured to focus incident radiation or incident light. During operation of the photoelectric conversion device, the microlenses 160 direct incident radiation or incident light onto the underlying device regions 130. When incident radiation or incident light with sufficient energy strikes the device region 130, it generates an electron-hole pair, thereby producing a photocurrent.

Based on the photoelectric conversion device provided in any of the aforementioned embodiments, the embodiments of the present invention further provide a receiving sensor. The receiving sensor may comprise: the photoelectric conversion device according to any of the aforementioned embodiments; an analog front-end circuit configured to convert analog electrical signals generated by the photoelectric conversion device into digital signals; a digital processor configured to process the digital signals, wherein the processing may include, for example, noise filtering, digital signal smoothing, and other operations. It should be understood that the present application does not limit the number of photoelectric conversion devices included in the receiving sensor.

Based on the aforementioned receiving sensor, the embodiments of the present invention further provide a LiDAR system. The LiDAR system may comprise the aforementioned receiving sensor, which includes the photoelectric conversion device according to any of the aforementioned embodiments. The receiving sensor may be configured as a receiving sensor linear array or a receiving sensor planar array, and the present application does not impose limitations on the quantity or arrangement of receiving sensors. It should be understood that the LiDAR system further includes a transmitting sensor. The transmitting sensor is configured to emit detection laser light, which is reflected by a target object and subsequently received by the receiving sensor, thereby enabling detection of the target object. The transmitting sensor may be an Edge-Emitting Laser (EEL) or a Vertical-Cavity Surface-Emitting Laser (VCSEL). The present application does not restrict the number of transmitting sensors, meaning the system may include one or multiple transmitting sensors. Multiple transmitting sensors may be arranged in a linear array or a planar array, and the present application does not impose a unique limitation on their arrangement. The correspondence between transmitting sensors and receiving sensors may be one-to-one, one-to-many, or many-to-one, and the present application does not impose a unique limitation on this relationship.

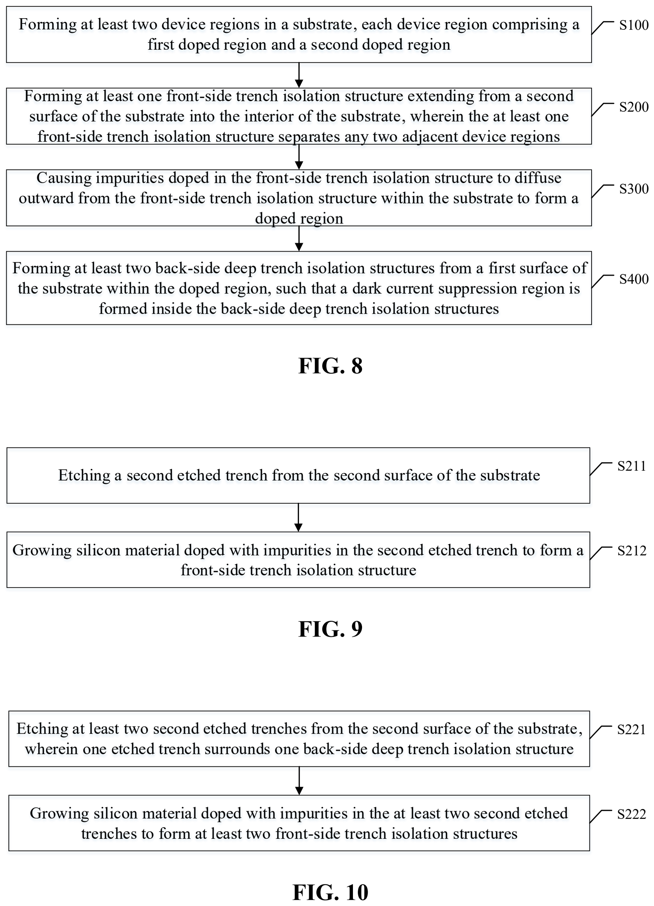

In view of the photoelectric conversion device provided in the aforementioned embodiments, the embodiments of the present invention provide a method for fabricating a photoelectric conversion device. A schematic flowchart of the method is shown in FIG. 8, which specifically includes the following steps:
Step S100: Forming at least two device regions in a substrate, each device region comprising a first doped region and a second doped region.
Step S200: Forming at least one front-side trench isolation structure extending from a second surface of the substrate into the interior of the substrate, wherein the at least one front-side trench isolation structure separates any two adjacent device regions.
Step S300: Causing impurities doped in the front-side trench isolation structure to diffuse outward from the front-side trench isolation structure within the substrate to form a doped region.
Step S400: Forming at least two back-side deep trench isolation structures from a first surface of the substrate within the doped region, such that a dark current suppression region is formed inside the back-side deep trench isolation structures.

In some embodiments of the present application, step S200 specifically includes the following sub-steps to form the photoelectric conversion device shown in FIG. 2. A schematic flowchart of this process is illustrated in FIG. 9:
Step S211: Etching a second etched trench from the second surface of the substrate.
Step S212: Growing silicon material doped with impurities in the second etched trench to form a front-side trench isolation structure.

In other embodiments of the present application, step S200 specifically includes the following sub-steps to form the photoelectric conversion device shown in FIG. 4. A schematic flowchart of this process is also illustrated in FIG. 9:
Step S221: Etching at least two second etched trenches from the second surface of the substrate, wherein one etched trench surrounds one back-side deep trench isolation structure.
Step S222: Growing silicon material doped with impurities in the at least two second etched trenches to form at least two front-side trench isolation structures.

Finally, it should be noted that the above embodiments are merely intended to illustrate the technical solutions of the present application rather than to limit them. Under the concept of the present application, technical features from the above embodiments or different embodiments may be combined, and steps may be implemented in any order. Numerous other variations of the different aspects of the present application, as described above, exist but have not been provided in detail for the sake of brevity. Although the present application has been described in detail with reference to the foregoing embodiments, those of ordinary skill in the art should understand that they may still modify the technical solutions described in the foregoing embodiments or equivalently replace some of the technical features. Such modifications or replacements do not cause the essence of the corresponding technical solutions to depart from the scope of the technical solutions of the embodiments of the present application.

## Claims

1. A photoelectric conversion device, comprising:
a substrate;
a front-side trench isolation structure;
at least two avalanche diode units formed in the substrate, each of the avalanche diode units comprising a device region and a back-side deep trench isolation structure surrounding the device region; and
a doped region formed by outward diffusion from the front-side trench isolation structure, the doped region having a doping concentration gradient that gradually decreases outward from the front-side trench isolation structure,
wherein at least one front-side trench isolation structure is provided between any two adjacent avalanche diode units; and
at least a portion of the doped region extends beyond the back-side deep trench isolation structure, forming a dark current suppression region in each of the two adjacent avalanche diode units.

2. The photoelectric conversion device according to claim 1, wherein one front-side trench isolation structure is provided between any two adjacent avalanche diode units;
wherein the front-side trench isolation structure is located between the back-side deep trench isolation structures of the two adjacent avalanche diode units.

3. The photoelectric conversion device according to claim 2, wherein a distance between a centerline of the front-side trench isolation structure and an inner side of the back-side deep trench isolation structure of the adjacent avalanche diode unit is defined as a first distance;
a distance between the centerline of the front-side trench isolation structure and a minimum effective concentration boundary of the doped region, the minimum effective concentration boundary having a predetermined doping concentration is defined as a second distance; and
the first distance is less than the second distance.

4. The photoelectric conversion device according to claim 1, wherein each avalanche diode unit has a corresponding front-side trench isolation structure,
wherein the corresponding front-side trench isolation structure surrounds the back-side deep trench isolation structure of the avalanche diode unit, and the corresponding front-side trench isolation structure is located outside the back-side deep trench isolation structure.

5. The photoelectric conversion device according to claim 4, wherein a distance between an outer side of the back-side deep trench isolation structure of the avalanche diode unit and a centerline of the corresponding front-side trench isolation structure is defined as a third distance;
the fourth distance is a distance between the centerline of the corresponding front-side trench isolation structure and a minimum effective concentration boundary of the doped region formed by diffusion from the corresponding front-side trench isolation structure, the minimum effective concentration boundary having a predetermined doping concentration is defined as a fourth distance; and
the third distance is less than the fourth distance.

6. The photoelectric conversion device according to claim 1, wherein the back-side deep trench isolation structure is a first etched trench filled with an isolation material;
wherein the isolation material comprises a metal and a high-dielectric-constant dielectric material.

7. The photoelectric conversion device according to claim 6, wherein the first etched trench is formed by an etching process from a first surface of the substrate.

8. The photoelectric conversion device according to claim 7, wherein a microlens is further disposed on the first surface of the substrate.

9. The photoelectric conversion device according to claim 7, wherein the front-side trench isolation structure is a second etched trench formed by growing silicon material through vapor-phase epitaxy;
wherein the silicon material is doped with impurities.

10. The photoelectric conversion device according to claim 9, wherein the front-side trench isolation structure is defined by the second etched trench;
wherein the second etched trench is formed by an etching process from a second surface of the substrate, the second surface being opposite to the first surface.

11. A receiving sensor, comprising:
the photoelectric conversion device according to any one of claims 1-10;
an analog front-end circuit configured to convert analog electrical signals generated by the photoelectric conversion device into digital signals; and
a digital processor configured to process the digital signals.

12. A LiDAR, comprising:
a transmitting sensor configured to emit detection laser light; and
the receiving sensor according to claim 11, configured to receive echo signals reflected from a target object after the detection laser light is reflected.
